# EUROPEAN PATENT SPECIFICATION

(11) **EP 0 418 802 B1**
(45) Date of publication and mention of the grant of the patent: **12.02.1997**
(21) Application number: 90117908.5
(22) Date of filing: 18.09.1990
(51) Int. Cl.: H01L 23/52, H01L 23/528, G06F 11/20

(54) **Wiring structure in a wafer-scale integrated circuit**
Leiterstruktur mit grösstintegrierter Schaltung auf einem Wafer
Structure de conducteurs dans un circuit intégré à échelle de plaquette

(30) Priority: 20.09.1989 JP 244554/89
(43) Date of publication of application: 27.03.1991
(73) Proprietor: FUJITSU LIMITED, Kawasaki-shi, Kanagawa 211 (JP); FUJITSU VLSI LIMITED, Kasugai-shi Aichi 487 (JP)
(72) Inventor: Murao, Toshiaki, c/o Fujitsu Limited, Nakahara-ku, Kawasaki-shi, Kanagawa 211 (JP); Kikuchi, Takeo, c/o Fujitsu Limited, Nakahara-ku, Kawasaki-shi, Kanagawa 211 (JP); Iryu, Toshihiko, c/o Fujitsu Limited, Nakahara-ku, Kawasaki-shi, Kanagawa 211 (JP); Sugamoto, Hiroyuki, c/o Fujitsu Limited, Nakahara-ku, Kawasaki-shi, Kanagawa 211 (JP); Nomura, Hidenori, c/o Fujitsu Limited, Nakahara-ku, Kawasaki-shi, Kanagawa 211 (JP)
(74) Representative: Sunderland, James Harry

(56) References cited:
- WO-A-89/12320
- DE-A- 3 516 995
- GB-A- 2 178 204
- IBM TECHNICAL DISCLOSURE BULLETIN, vol. 32, no. 2, July 1989, pages 405-406, New York, US; "Redundancy and logic-EC scheme for passive superchip"
- 23RD ELECTRONIC COMPONENTS CONFERENCE, Washington, D.C., 14th - 16th May 1973, pages 7-14; D.F. CALHOUN et al.: "Status and future directions of pad relocation full wafer LSI"

## Description

The present invention relates to a wiring structure in a semiconductor wafer-scale integrated circuit (hereinafter referred to as an IC).

A wafer-scale IC comprises a plurality of identical functional blocks, having memories and logic circuits for control thereof, and operates as a single device without separating these blocks. Therefore, the wafer-scale IC can integrate circuitry on a larger scale than any other IC, and can reduce signal delay time due to the provision of shorter wiring distances between IC chips than is the case for a conventional plurality of ICs each being an individual IC chip in a package. Moreover, since processes for assembling individual IC chips are naturally unnecessary, circuit fabrication processes for wafer-scale ICs can be simplified, and accordingly device reliability can be improved. Recent wafer-scale ICs provide a memory capacity of 200 M bits on a single wafer 15 cm in diameter.

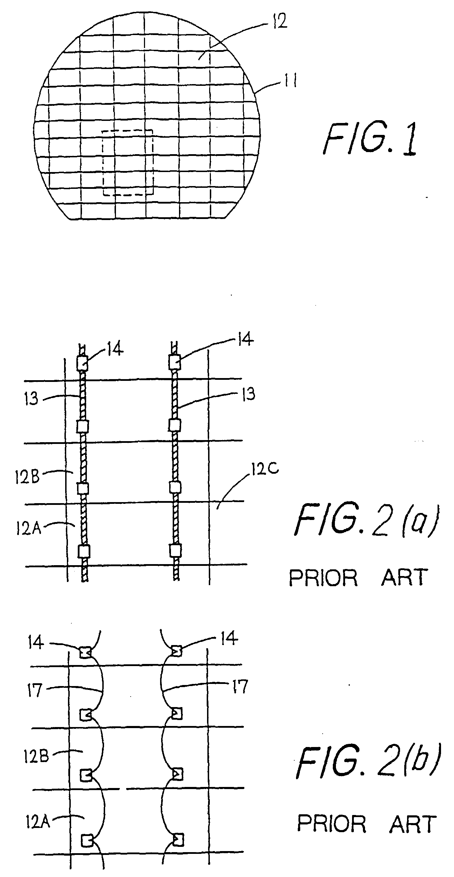

Fig. 1 schematically shows a plan view of a wafer-scale IC. A wafer 11 having 26 rows x 9 columns of functional blocks 12 is mounted on a circuit board (not illustrated), formed of resin, etc., called a carrier. Fig. 2(a) is a plan view showing to an enlarged scale that part of Fig. 1 enclosed by broken lines. Functional blocks 12 are fabricated by repeated exposures of a reticule of a single block, for rows and columns in a matrix, in a step and repeat method. Therefore, terminal electrodes (pads) 14 for the supply of source voltages to the functional blocks are aligned in lines. Accordingly, lengths of power-supply layer-wiring 13 for supplying source voltage to each of the functional blocks are connected in series via pads, and each pad is connected in parallel to each functional block on a line, as shown in Fig. 2(a). Wiring 13 is connected to the carrier (not illustrated) by a bonding wiring via terminal electrodes (not illustrated) provided at an edge part of wafer 11, so as to receive power source voltage. Power supply layer-wiring 13 is usually formed by a metal film pattern about several tens of micrometres in width and about 1 µm in thickness. As this power supply layer-wiring extends from one edge to another edge of a wafer as large as 15 cm in diameter, its resistance and inductance are both increased. Connection to adjacent functional blocks is effected by overlapping the patterned wiring at the connecting areas of the blocks during exposures for forming the functional blocks using the reticule. However, reticule exposure of such a large pattern cannot easily maintain alignment accuracy at peripheral parts thereof, and the wafer itself does not always have sufficient surface flatness since many layers have been already fabricated thereon prior to formation of the layer-wiring, resulting in a problem in terms of reliability in comparison with the layer wiring usually formed by a single patterning. In order to avoid this problem, power supply terminals 14 of each functional block may be connected by bonding wires 17 as shown in Fig. 2(b), in place of layer-wiring 13. Since bonding wire 17 is typically formed of aluminium or gold 30 to 100 µm in diameter, its resistance and inductance can be significantly lower than that of layer wiring 13. However, even if a bonding wire is employed, since the power source voltage is supplied via serially-connected wirings to as many as (typically) twenty-six functional blocks, a single wire-break results in failure of power supply to all the functional blocks beyond the broken wiring point, resulting in a reliability problem for the device. The above-explained structure, where the power supply wiring is constituted by layer wiring or is constituted by bonding wire, is described in European Patent Application EP-A-0 345 162, included in the state of the art in accordance with Article 54(3) EPC.

WO-89/12320, included in the state of the art in accordance with Article 54(3) EPC, describes a wafer scale integrated circuit in which like integrated circuits or "chips" on a wafer are supplied with power V_{cc} and Vₛₛ by bondwires stitch bonded to pads on all chips. The bondwires are interrupted at the equator of the wafer, so that a supply line fault in the top half of the wafer will not affect any chips in the lower half, and vice-versa. Global signal lines (Wafer Clock and Command) are treated similarly, being formed in metal which is interrupted at the equator.

Thus, it is desirable to provide a method of supplying source voltage to each functional block of a wafer-scale IC, whilst satisfying requirements for high reliability.

According to the present invention there is provided a semiconductor wafer-scale integrated circuit comprising:-
a single wafer;
a plurality of functional blocks formed on said wafer;
bonding wire interconnecting predetermined connection electrodes provided in respective different ones of said functional blocks, and
layered wiring interconnecting said predetermined connection electrodes provided in respective different ones of said functional blocks, in addition to and electrically in parallel with said bonding wire.

An embodiment of the present invention can provide a wafer-scale integrated circuit, formed on a single wafer, wherein reliable wiring connections to each of the functional blocks fabricated therein is secured.

In an embodiment of the present invention, on a wafer-scale integrated circuit, pad electrodes, for receiving a common voltage and provided on each of a plurality of identical functional blocks, are connected with each other dually by layered wirings as well as bonding wires. With the use of two different types of connection wirings, connection failure modes are different for the respective wiring types, resulting in an increased reliability of the wafer-scale integrated circuit. Thus, dually connected wirings are advantageous particularly in the case where wirings between adjacent functional blocks are serially connected with each other so as to commonly supply the power source voltage via the connection electrodes provided thereon to the functional blocks.

Reference is made, by way of example, to the accompanying drawings, in which:-
Fig. 1 schematically illustrates a wafer of a wafer-scale integrated circuit;
Figs. 2(a) and 2(b) schematically illustrate prior art connection methods used for supplying voltage commonly to each of a plurality of functional blocks in a wafer-scale integrated circuit;
Fig. 3(a) schematically illustrates a basic embodiment of the present invention;
Fig. 3(b) schematically illustrates overlapping layer wiring of adjacent functional blocks, as employed in an embodiment of the present invention;
Fig. 4 is a block diagram of a functional block which may be fabricated in a wafer-scale integrated circuit in accordance with an embodiment of the present invention;
Fig. 5 illustrates, in more detail, features of an example of an embodiment of the present invention; and
Fig. 6 schematically illustrates another basic embodiment of the present invention.

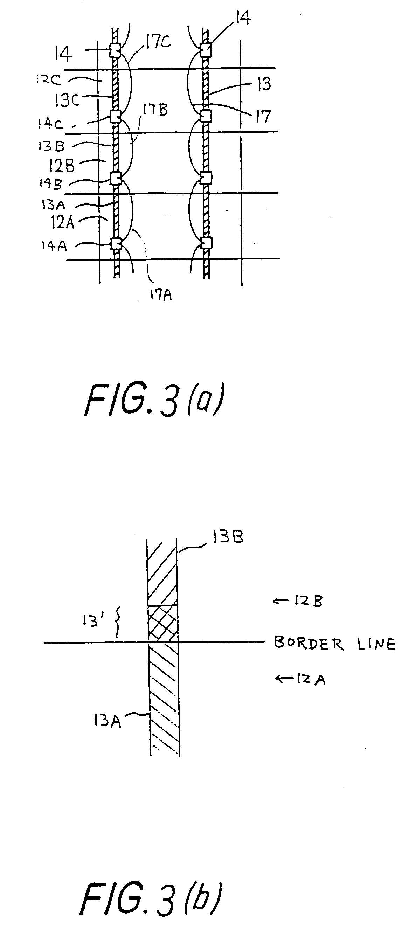

Fig. 3(a) is a schematic plan view illustrating a basic embodiment of the present invention. The numerals 12A, 12B, ..... of Fig. 3 indicate a plurality of functional blocks fabricated on a single wafer of 15 cm diameter, as shown in Fig. 1. Each of the functional blocks is, for example, 13.65 x 4.4 mm in size, and comprises therein, for example, a 1 M bit DRAM (dynamic random access memory) and its control circuit. An example of details of each functional block and the overall structure of a wafer will be explained below. Each functional block is fabricated, as is well known, by a step and repeat method in which a reticule having the pattern of a single functional block is repeatedly exposed by selecting desired matrix positions upon semiconductor wafer 11. Therefore, connection terminals 14 provided for receiving power source voltages Vcc, Vss, etc., from circuits external to the functional blocks are aligned, on straight lines in the example illustrated.

Layer wirings 13A, 13B, 13C, ....., used to supply power source voltage, such as Vcc or Vss, to each of the functional blocks are typically about 50 µm wide, about 1 µm thick and typically formed of aluminium film, and are sequentially connected to each of a series of power supply terminals 14A, 14B, 14C, ..... of respective functional blocks 12A, 12B, ....., aligned in a vertical line.

The reticule pattern for fabricating layer wiring 13A of functional block 12A, for instance, to be connected to the adjacent functional block 12B, is extended beyond the border line of the blocks into the adjacent block 12B by as much as about 10 µm, as denoted by 13′ shown in Fig. 3(b). Therefore, portion 13′ of layer wiring 13A is deposited so as to overlap layer wiring 13B of the next functional block 12B.

Power supply terminals 14A, 14B, 14C, ....., connected by layer wirings 13A, 13B, 13C, ....., are sequentially connected in series by bonding wires 17A, 17B, 17C, ..... of 30 to 100 µm diameter consisting of aluminium or gold, by means of, for example, the well-known ultrasonic bonding method, as shown in Fig. 3(a).

Thus, power source terminals 14 of functional blocks are connected with each other by layer wirings 13 and also by bonding wires 17.

As explained above, the functional blocks are each as large as, for example, 13.65 x 4.4 mm and as many as two hundred or more may be mounted on a single wafer. Therefore, it is hardly to be expected that all the functional blocks on the wafer are free from defects. However, since only a small number of functional blocks will be found to be defective in practice, selective employment of only the defect-free functional blocks allows the achievement of a 200 M bit memory.

All the functional blocks are tested in advance with a probe so as to detect defective functional blocks, and thus-obtained positional information identifying the defective blocks is stored in an EPROM (erasable programmable read only memory) mounted on the carrier supporting the wafer thereon. Based on the positional information identifying the defective functional blocks, each of the functional blocks is instructed as to which one of four surrounding blocks (east, west, south and north) memory information should be transmitted to. A control circuit which, upon receiving such instruction, establishes a signal connection to the relevant adjacent functional blocks in accordance with the instruction, is called a configuration logic circuit and is, therefore, provided in each functional block.

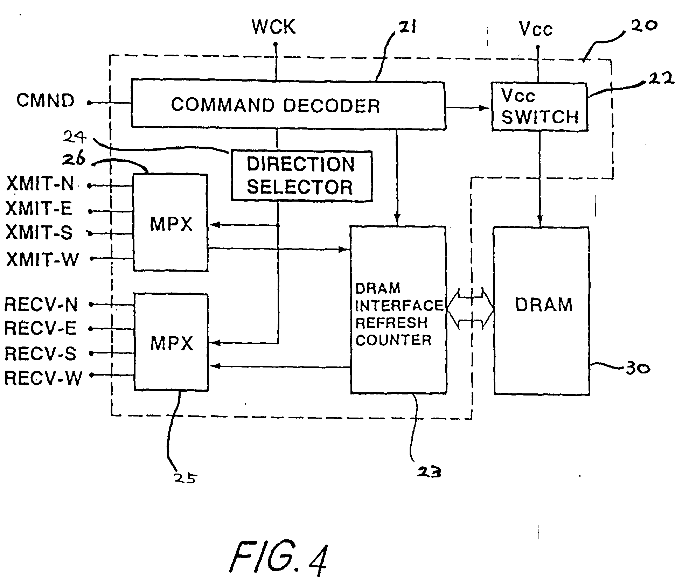

An exemplary structure of a functional block is shown in the block diagram of Fig. 4. A part 20 enclosed by broken lines indicates the configuration logic circuit. The configuration logic circuit comprises command decoder 21, Vcc switch 22, DRAM interface refresh counter 23, direction selector 24 and multiplexers 25 and 26. Command detector 21 receives and decodes an instruction CMND input from an external circuit synchronously with a synchronisation signal WCK, so as to issue instructions to other circuits in the functional block. Vcc switch 22 controls supply of power source voltage Vcc to DRAM 30. DRAM interface refresh counter 23 generates signals required for the operation of DRAM 30, such as load address strobe signals, column address strobe signals, write-enable signals, output-enable signals and address signals, given from the signal supplied from command decoder 21. These signals are used for read/write and refresh operations of DRAM 30. Direction selector 24 issues an instruction to receiving multiplexer 25 and sending multiplexer 26 respectively to instruct which one of adjacent functional blocks a signal should be received from, as well as which one of the adjacent functional blocks a signal should be sent to. Receiving multiplexer 25 selectively connects only one of input terminals of signals RECV-N, E, S and W respectively from the four adjacent functional blocks. The last characters of these signal names respectively denote connections with North, East, South or West adjacent blocks, and their terminals are respectively provided on the North, East, South and West sides of each functional block. Sending multiplexer 26 selectively connects only one of output terminals of signals XMIT-N, E, S and W respectively to the four adjacent functional blocks. The selective connections of these input and output terminals are all carried out by a program based on the positional information identifying defective functional blocks, as already described. Thus, memory information is transmitted only via defect-free functional blocks and the DRAM information of each functional block is serially input/output from/to the outside of wafer 11. In this way, DRAMs of a size of as much as 200 M bits can be fabricated on single wafers with acceptable production yield.

A wafer scale IC memory having a functional block structure as described above has been reported in a paper entitled "200 Mb WAFER MEMORY" by N. MacDonald et al., in 1989 IEEE ISSCC DIGEST of TECHNICAL PAPERS, pages 240 to 241. In this report, the functional block is called a chip. Furthermore reference is made to GB-A-2 178 204.

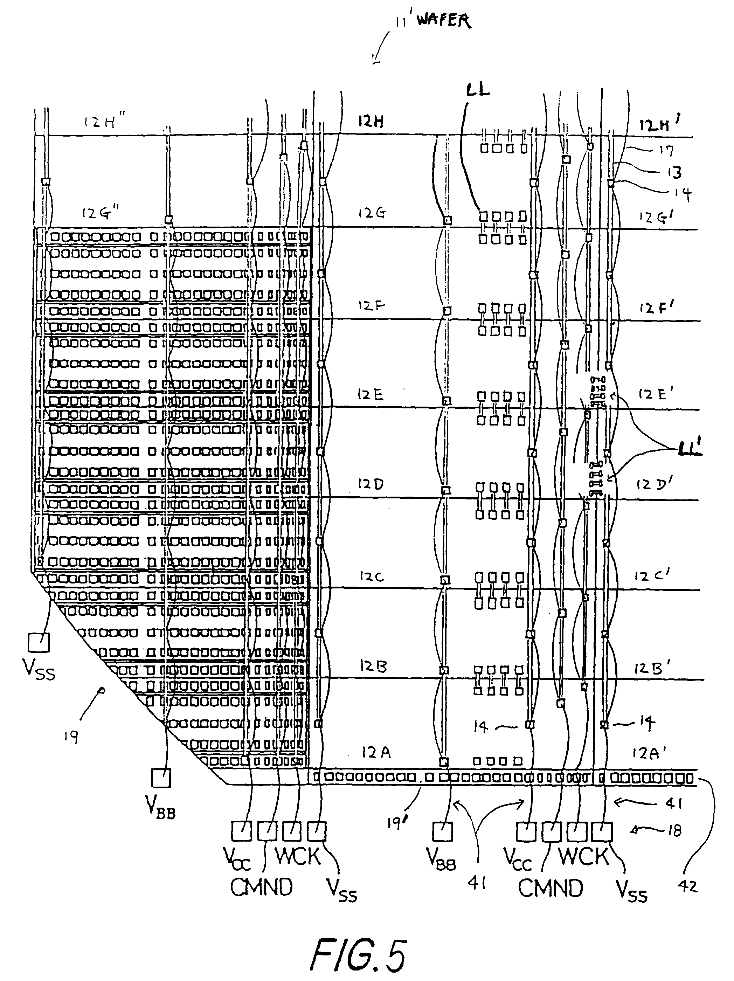

Fig. 5 shows an enlarged partial detail view of an example of a wafer-scale IC configured in accordance with the basic embodiment of the present invention illustrated in Fig. 3(a).

On a wafer 11′, unusable arc portions located at the periphery of wafer 11 of Fig. 1 are cut away. Connecting terminals receiving in parallel voltages from external circuits, for example, from a Vcc power supply terminal, a Vbb substrate voltage terminal, a clock (WCK) terminal and a command (CMND) terminal, provided in respective functional blocks 12A, 12B, 12C, ..... are aligned in vertical lines and are doubly connected with each other in the lines by layer wiring 13 and bonding wires 17. In order to supply voltages to these double wirings, there are provided a plurality of connection terminals 42 in an extra block 19′ provided below and to the outside of functional blocks 12A and 12A′ on the wafer. Each of the connection terminals 42 is connected to a respective one of connection terminals 14 in functional blocks 12A and 12A′ (12B), and to a respective one of external terminals 18 by wire bonding 41. In other words, a connection terminal 42 functions as a relay terminal between an external source and the functional blocks. Thus, power source voltages and signals are input in parallel to each of the functional blocks.

Blocks 19, which are located at the periphery of wafer 11′ and are unusable as functional blocks, are provided with connecting terminals, i.e. pads, for extending the wirings, so that these pads aligned vertically are connected with each other doubly by layer wiring and by bonding wires in order to supply the power source voltage to the functional blocks 12G˝, 12H˝, ..... aligned vertically above these unusable blocks 19.

Moreover, there are provided local wirings LL for sending/receiving signals between vertically adjacent functional blocks, for example, 12F and 12G, and local wirings LL′ for sending/receiving signals between the horizontally adjacent functional blocks, for example, between 12D and 12D′, and between 12E and 12E′ shown in Fig. 5.

In Fig. 5, illustration of the wirings of power source voltage Vss and clock WCK is partly omitted in order to allow illustration of the local wirings LL′.

These local wirings LL and LL′ are formed only with layer wiring made of aluminium. This is because connections which are not serial (for example, not like the wirings for power source voltages or clock signals) are of lesser significance: even if one of the connections become defective the adverse effects are restricted. However, it is apparent that the duplicated wirings according to the present invention can also be applied thereto, resulting in an advantageous effect. Moreover, though not illustrated in Fig. 4, each functional block 20 is provided with layer wiring LL of Fig. 5 for sending/receiving signals RECV/XMIT to/from the adjacent functional blocks.

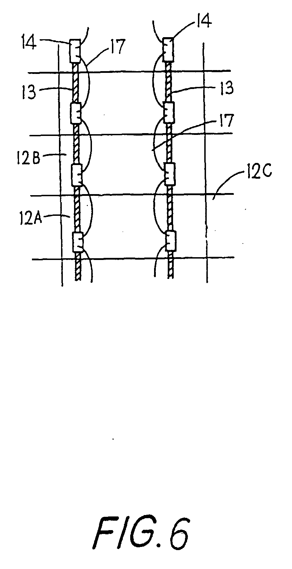

Fig. 6 is a plan view illustrating another basic embodiment of the present invention. Elements like those found in Fig. 3(a) are designated by like reference signs. Fig. 6 is different from Fig. 3(a) only in the method of wiring bonding. As shown in Fig. 6, bonding wire 17 is cut or separated at each connection terminal 14 and the welding positions of two bonding wire ends on a connection terminal 14 are displaced from one another on the connection terminal 14.

In the double wiring structure of an embodiment of the present invention, the layer wiring is superior in terms of its vibration-resistance characteristics, even though it suffers a problem in relation to patterning with a reticule, but on the other hand the wire bonding is superior in reliability even though it suffers a problem in relation to its vibration-resistance characteristics. Thus, the double wirings of an embodiment of the present invention, having different failure modes, serve to improve reliability remarkably. Particularly in relation to the structure used for branching (distributing) voltages, such as power source voltages or clock signal voltage, to each of the functional blocks via serial wirings, the improvement in the reliability of wirings directly contributes to the improvement in reliability of the devices.

An embodiment of the invention can provide a wafer-scale integrated-circuit, formed on a single wafer, which has a reliable connection of wirings to each of the functional blocks in the wafer-scale IC.

On a wafer-scale integrated circuit, pad electrodes, for commonly receiving a voltage, such as power supply voltage and clock signal, provided on each of a plurality of identical functional blocks, are connected with each other in duplicate by layered wirings and bonding wires electrically in parallel to each other. Owing to the two different types of connection wirings, failure modes are different for the respective wiring types, resulting in an increased reliability of the wafer scale integrated circuit. Dually connected wirings are particularly advantageous in a case in which wiring between two adjacent functional blocks is in series to the wiring of the oppositely adjacent functional blocks, i.e. the wirings for commonly supplying the power source voltage via serially-connected wirings to the functional blocks.

## Claims

1. A semiconductor wafer-scale integrated circuit comprising:-
a single wafer (11; 11');
a plurality of functional blocks (12A, 12B, etc.) formed on said wafer (11; 11');
bonding wire (17; 17A, 17B, etc.) interconnecting predetermined connection electrodes (14) provided in respective different ones of said functional blocks (12A, 12B, etc.), and
layered wiring (13; 13A, 13B, etc.) interconnecting said predetermined connection electrodes (14) provided in respective different ones of said functional blocks (12A, 12B, etc.), in addition to and electrically in parallel with said bonding wire (17; 17A, 17B , etc.).

2. A semiconductor wafer-scale integrated circuit as claimed in claim 1, wherein said connection electrodes (14) are for supplying a voltage to said functional blocks (12A, 12B, etc.) commonly, from outside of said functional blocks.

3. A semiconductor wafer-scale integrated circuit as claimed in claim 1 or 2, wherein said connection electrodes (14) are for supplying a power-source voltage.

4. A semiconductor wafer-scale integrated circuit as claimed in claim 1 or 2, wherein said connection electrodes (14) are for supplying a clock signal voltage.

5. A semiconductor wafer-scale integrated circuit as claimed in any preceding claim, wherein said plurality of functional blocks (12A, 12B, etc.) are identical with each other.

6. A semiconductor wafer-scale integrated circuit as claimed in any preceding claim, wherein each of said functional blocks (12A, 12B) comprises a semiconductor memory (30) and a configuration logic circuit (20).

## Patentansprüche

1. Ultrahöchstintegrierte Halbleiterschaltung, umfassend:
einen Einzelwafer (11; 11');
eine Anzahl Funktionsblöcke (12A, 12B, usw.), die auf dem Wafer (11; 11') ausgebildet sind;
Bonddrähte (17; 17A, 17B, usw.), die vorbestimmte Anschlußelektroden (14) verbinden, die in jeweils voneinander verschiedenen Funktionsblöcken (12A, 12B, usw.) bereitgestellt sind; und
Schichtverdrahtungen (13; 13A, 13B, usw.), die die vorbestimmten Anschlußelektroden (14) verbinden und in jeweils voneinander verschiedenen Funktionsblöcken (12A, 12B, usw.) zusätzlich zu den Bonddrähten (17; 17A, 17B, usw.) bereitgestellt und zu den Bonddrähten parallel geschaltet sind.

2. Ultrahöchstintegrierte Halbleiterschaltung nach Anspruch 1, wobei die Anschlußelektroden (14) dazu dienen, den Funktionsblöcken (12A, 12B, usw.) gemeinsam eine Versorgungsspannung von außen zuzuführen.

3. Ultrahöchstintegrierte Halbleiterschaltung nach Anspruch 1 oder 2, wobei die Anschlußelektroden (14) dazu dienen, die Spannung einer Versorgungsspannungsquelle zuzuführen.

4. Ultrahöchstintegrierte Halbleiterschaltung nach Anspruch 1 oder 2, wobei die Anschlußelektroden (14) dazu dienen, eine Taktsignalspannung zuzuführen.

5. Ultrahöchstintegrierte Halbleiterschaltung nach irgendeinem vorhergehenden Anspruch, wobei die Funktionsblöcke (12A, 12B, usw.) untereinander identisch sind.

6. Ultrahöchstintegrierte Halbleiterschaltung nach irgendeinem vorhergehenden Anspruch, wobei jeder der Funktionsblöcke (12A, 12B, usw.) einen Halbleiterspeicher (30) und eine Konfigurierlogikschaltung (20) enthält.

## Revendications

1. Circuit intégré à semiconducteur pleine plaquette comprenant :
une unique plaquette (11 ; 11') ;
une pluralité de blocs fonctionnels (12A, 12B, etc...) formés sur ladite plaquette (11 ; 11') ;
un fil de liaison (17 ; 17A, 17B, etc...) interconnectant des électrodes de connexion prédéterminées (14) prévues dans certains différents respectifs desdits blocs fonctionnels (12A, 12B, etc...) ; et
un câblage en couche (13 ; 13A, 13B, etc...) interconnectant lesdites électrodes de connexion prédéterminées (14) prévues dans certains différents respectifs desdits blocs fonctionnels (12A, 12B, etc...) en plus dudit fil de liaison (17 ; 17A, 17B, etc...) et électriquement en parallèle à celui-ci.

2. Circuit intégré à semiconducteur pleine plaquette selon la revendication 1, dans lequel lesdites électrodes de connexion (14) sont prévues pour appliquer une tension auxdits blocs fonctionnels (12A, 12B, etc...) en commun, depuis l'extérieur desdits blocs fonctionnels.

3. Circuit intégré à semiconducteur pleine plaquette selon la revendication 1 ou 2, dans lequel lesdites électrodes de connexion (14) sont prévues pour appliquer une tension d'alimentation.

4. Circuit intégré à semiconducteur pleine plaquette selon la revendication 1 ou 2, dans lequel lesdites électrodes de connexion (14) sont prévues pour appliquer une tension de signal d'horloge.

5. Circuit intégré à semiconducteur pleine plaquette selon l'une quelconque des revendications précédentes, dans lequel les blocs de ladite pluralité de blocs fonctionnels (12A, 12B, etc...) sont identiques les uns aux autres.

6. Circuit intégré à semiconducteur pleine plaquette selon l'une quelconque des revendications précédentes, dans lequel chacun desdits blocs fonctionnels (12A, 12B) comprend une mémoire semiconductrice (30) et un circuit logique de configuration (20).
